Europäisches Patentamt

European Patent Office

Office européen des brevets

(19)

(11) Veröffentlichungsnummer: **0 332 948**
**A2**

## (12) EUROPÄISCHE PATENTANMELDUNG

(21) Anmeldenummer: 89103712.9

(22) Anmeldetag: 03.03.89

(51) Int. Cl.⁴: **C25D 3/02** , **C25D 5/54** , **C04B 41/51**

(30) Priorität: 18.03.88 DE 3809672

(43) Veröffentlichungstag der Anmeldung:
20.09.89 Patentblatt 89/38

(84) Benannte Vertragsstaaten:
BE CH DE ES FR GB IT LI LU NL SE

(71) Anmelder: SCHERING AKTIENGESELLSCHAFT
Berlin und Bergkamen
Müllerstrasse 170/178 Postfach 65 03 11
D-1000 Berlin 65(DE)

(72) Erfinder: Majentny, Klaus
Ludolfingerweg 54a
D-1000 Berlin 28(DE)
Erfinder: Middeke, Hermann-Josef, Dr.
Sächsische Strasse 12
D-1000 Berlin 31(DE)
Erfinder: Zakel, Elke
Guinea Strasse 4
D-1000 Berlin 65(DE)

(54) Verfahren zur Herstellung von hochtemperaturbeständigen Metallschichten auf Keramikoberflächen.

(57) Die Erfindung betrifft ein Verfahren zur Herstellung von hochtemperaturbestän digen, insbesondere blasenfreien, Metallschichten auf Keramikoberflächen durch galvanische Metallabscheidung, dadurch gekennzeichnet, daß wasserfreie oder wasserarme galvanische Bäder verwendet werden.

EP 0 332 948 A2

# VERFAHREN ZUR HERSTELLUNG VON HOCHTEMPERATURBESTÄNDIGEN METALLSCHICHTEN AUF KERAMIKOBERFLÄCHEN

Die Erfindung betrifft ein Verfahren zur Herstellung von hochtemperaturbeständigen, insbesondere blasenfreien Metallschichten auf Keramikoberflächen durch galvanische Metallabscheidung.

Die galvanische Metallabscheidung auf Keramikoberflächen ist bereits bekannt.

Der Nachteil dieser Verfahrensweise ist jedoch, daß eine Metallschicht mit den üblichen abgeschiedenen galvanischen Bädern nur Temperaturen bis maximal etwa 300° C toleriert. Oberhalb dieser Temepratur bilden sich Blasen, die den Verbund Keramik-Metall weitgehend zerstören. Die Ursache dieser Blasenbildung ist nicht mit Sicherheit bekannt, kann jedoch möglicherweise auf die Einlagerung von bei höheren Temperaturen gasbildenden Stoffen zurückgeführt werden.

Die vorliegende Erfindung hat die Aufgabe, ein Verfahren zu schaffen, welches die Herstellung von hochtemperaturbeständigen, insbesondere blasenfreien Metallschichten auf Keramikoberflächen ermöglicht.

Diese Aufgabe wird erfindungsgemäß durch ein Verfahren gemäß dem kennzeichnenden Teil des Patentanspruchs gelöst.

Weitere Ausgestaltungen sind den Kennzeichnungsteilen der Unteransprüche zu entnehmen.

Die erfindungsgemäß auf Keramikoberflächen abgeschiedenen Metallschichten sind überraschenderweise bis zu Temperaturen von 500° C und mehr beständig und zeigen keine Blasenbildung, was technisch insbesondere für ihre Verwendung in der Elektrotechnik, zum Beispiel als Leiterplatten, von außerordentlichem Vorteil ist.

Als Substrate kommen handelsübliche Keramiken zum Einsatz wie die verschiedenen Sorten von Alkuminiumoxidkeramik oder Aluminiumnitridkeramik oder Keramiken wie Berylliumoxidkeramik oder zum Beispiel Bariumtitanat. Diese werden in üblicher Weise vorbehandelt, das heißt mit einer dünnen Metallschicht vorzugsweise Kupfer überzogen. Es ist aber auch Nickel, Kobalt oder Gold als Grundmetallisierung einsetzbar.

Die erfindungsgemäß zu verwendenden galvanischen Bäder enthalten in der Regel die folgenden Komponenten:

Ein organisches Lösungsmittel, das vorzugsweise polare Gruppen, wie -CO-NH-, -CO- oder O- enthält oder Komplexe bilden kann, wie zum Beispiel Alkohole, wie Ethanol, i-Propanol oder n-Butanol, oder Ether, wie Diethylether, Tetrahydrofuran oder Diethylenglykolether, oder aromatische Kohlenwasserstoffe, wie Toluol oder Xylol, oder Lösungsmittel, wie N,N-Dimethylformamid, N-Methylpyrrolidon oder Acetylaceton.

Ein oder mehrere Verbindungen der Metalle Blei, Cadmium, Chrom, Eisen, Gold, Kobalt, Kupfer, Nickel, Palladium, Platin, Zink, Zinn, Rhodium in Form ihrer Verbindungen, wie zum Beispiel als Sulfat, Sulfonat, Halogenid, Nitrat oder als Salz einer organischen Säure, wie Essigsäure oder Bernsteinsäure, oder als Metallkomplex mit Komplexbildnern wie Acetylacetonat, Acetacetat oder Tetrahydrofuran. Bevorzugt können hier auch Stoffe eingesetzt werden, die als Resinate bekannt sind. Sie sind die Metallsalze der Harzsäuren, trizyklischen, alphatischen, ungesättigten Monocarbonsäuren wie Lävopimarsäure, Neoabietinsäure, Palustrinsäure, Abietinsäure, Dehydroabietinsäure, Tetrahydroabietinsäure, Pimarsäure oder Isopimarsäure.

Die Metallverbindungen werden in Konzentrationen von 0,1 bis 150 g/Liter Badlösung bezogen auf den Metallgehalt angewendet.

Einer die Leitfähigkeit erhöhenden Substanz wie einer Säure, einer basischen Verbindung oder einem Leitsalz, wobei unter Säure beziehungsweise Base auch Lewis-Säuren wie $ALCl_3$ oder $BF_3$ oder entsprechende Lewis-Basen zu verstehen sind. Bevorzugt werden hier aber Protonen-abgebende Säuren eingesetzt, wie konzentrierte Schwefelsäure oder Methansulfonsäure sowie quartärer Ammoniumverbindungen wie zum Beispiel Tetrabutyl-Ammoniumtetrafluorborat. Die Konzentration der Leitfähigkeit erhöhenden Komponenten beträgt zweckmäßigerweise etwa 0,5 bis 350 g Liter Badlösung.

Einem oder mehreren Hilfsstoffen, die die Struktur der galvanisch abgeschiedenen Metallschicht für die Bildung von Glanz, Dichtigkeit oder Duktilität beeinflussen. Zum Einsatz können hier oberflächenaktive Substanzen, wie Tenside oder Redox-Systeme kommen.

Die erfindungsgemäß zu verwendenden Bäder müssen wasserfrei oder wasserarm sein, wie dies bei handelsüblichen Produkten in der Regel der Fall ist. Ein Wassergehalt von maximal 1 Gewichtsprozent sollte nicht überschritten werden.

Die Arbeitsbedingungen der erfindungsgemäß zu verwendenden Bäder sind wie folgt

Anwendbare Stromdichte: 0,2 - 3,0 A/dm², vorzugsweise 1,0 - 2,5 A/dm²
Arbeitstemperatur: 20 - 60° C, vorzugsweise 25 - 35° C

Die erfindungsgemäß metallisierten Keramik-Werkstücke finden insbesondere in der Elektroindustrie und Elektronik Verwendung.

Die folgenden Beispiele dienen zur Erläuterung der Erfindung.

## BEISPIEL 1

35g des Kupfersalzes einer Harzsäure, 35g Methansulfonsäure, 17g Tetrabutylammoniumtetrafluoroborat, werden in 600g N,N-Dimethylformamid (DMF) gelöst und dann mit DMF auf 1 Liter aufgefüllt. Als Anodenmaterial wird Elektrolytkupfer eingesetzt. Bei einer Mittleren Stromdichte von 1,0A/dm$^2$ erhält man einen reinen, feinkristallinen, seidenmatten Kupferüberzug. Die kathodische Stromausbeute liegt bei etwa 89%, die Arbeitstemperatur beträgt von 25°C bis 55°C.

## BEISPIEL 2

50 g des Kupfersalzes einer Harzsäure, 10g Tetrabutylammoniumtetrafluoroborat, 50 g Methansulfonsäure und 600g Acetylaceton (99%) werden gemischt und mit Acetylaceton auf einen Liter aufgefüllt. Als Anodenmaterial wird Elektrolytkupfer eingesetzt. Es kann ebenfalls Kupfer mit einem Gehalt von 0.05% Phosphor eingesetzt werden. Die anwendbare Stromdichte beträgt 0,2 - 1,5A/dm$^2$, vorzugsweise 1,0 A/dm$^2$. Die Arbeitstemperatur variiert von 25°C bis 60°C, vorzugsweise 35°C.

## BEISPIEL 3

Nickelsalz einer Harzsäure 150g, Methansulfonsäure 60g, N,N-Dimethylformamid 600g und Amidoschwefelsäure 15g werden gelöst und dann mit Dimethylformamid auf einen Liter aufgefüllt. Als Anodenmaterial wird Elektrolytnickel verwendet. Die mittlere Stromdichte beträgt 2,5A/dm$^2$, die Arbeitstemperatur liegt bei 40°C. Die kathodische Stromausbeute beträgt 98%. Die Niederschläge sind hellgrau und seidenglänzend mit sehr feiner Struktur.

## BEISPIEL4

Kupferacetylacetonat 80g, Methansulfonsäure 150g und N,N-Dimethylformamid 850g werden gelöst und mit Dimethylformamid auf einen Liter aufgefüllt. Als Anodenmaterial wird Elektrolytkupfer eingesetzt. Die anwendbare Stromdichte beträgt 0,5 bis 1,0A/dm$^2$ bei einer Arbeitstemperatur von 25°C bis 50°C.

## BEISPIEL 5

Eine Platte aus Al$_2$O$_3$ vom Format 2"2inch wird in bekannter Weise alkalisch aufgeschlossen, aktiviert und chemisch reduktiv mit einer etwa 3μm-

dicken Kupferschicht belegt. Die Platte wird danach entweder durch Anblasen getrocknet oder das Wasser durch Abspülen mit Ethanol entfernt. Anschließend wird die Kupferschicht auf der Platte in einem Bad aus N,N-Dimethylformamid, Kupfersulfat und Schwefelsäure bei 2A/dm$^2$ in 30 Minuten mit etwa 15μm Kupfer galvanisch verstärkt. Unter Schutzgas (Argon mit etwa 2% Wasserstoffgehalt) wird die Platte innerhalb von 12 Minuten auf 500°C erwärmt, 30 Minuten bei dieser Temperatur belassen und dann in 30 Minuten wieder auf Raumtemperatur abgekühlt. Die Metalloberfläche weist keine Schäden oder Veränderungen auf. Eine in gleicher Weise behandelte Keramikplatte, die aber im Gegensatz hierzu wässrig galvanisch verstärkt wird, zeigt eine blasige Oberfläche.

## BEISPIEL 6

Eine Keramikplatte aus Aluminiumnitrid, die in gleicher Weise aufgeschlossen und metallisiert worden war, wie in Beispiel 5 beschrieben, wurde in einem Nikkelbad galvanisch verstärkt, das aus dem Nickelsalz einer Harzsäure, N,N-Dimethylformamid und Methansulfonsäure bestand. In 30 Minuten wurde bei 2A/dm$^2$ eine Nickelschicht von 25 μm Dicke auf der Kupferoberfläche abgeschieden. Parallel dazu wurde auf dem aus einem wässrigen galvanischen Bad eine Nickelschicht von 23 μm abgeschieden. Nach dem Tempern bei 500°C unter Schutzgas wies die aus wässrigem Medium abgeschiedene Nickelschicht große Blasen auf, während die aus dem Dimethylformamid -Bad abgeschiedene Schicht keine Fehler aufwies. Ein metallografischer Querschliff durch den Verbund Keramik-Kupfer-Nickel zeigte hier den unverletzten Verbund auf. Im Gegensatz dazu zeigte das Nickel aus dem wässrigen Bad nach dem Tempern im Querschliiff eine große Menge von Rissen und Ablösung vom Kupfer oder von der Keramik.

## BEISPIEL 7

Eine vorverkupferte Al$_2$O$_3$ Platte wurde galvanisch in einem Bad vernickelt, das aus 1000 ml N-Methylpyrrolidon, 50g des Nickelsalzes einer Harzsäure und 20ml konzentrierter Schwefelsäure hergestellt worden war. Die hellgrüne Lösung lieferte bei 0,8A/dm$^2$ glänzende gut haftende Nickelschichten, die bis über 500°C temperaturstabil blieben.

## BEISPIEL 8

Eine vorverkupferte AlN-Platte wurde in einem Bad aus 50ml Methansulfonsäure und 75g des Nickelsalzes einer Harzsäure in 500 ml Ethanol bei einer Stromdichte von 2A/dm² vernickelt bis zu einer Schichtdicke des Nickels von 30μm. Die Nickelschicht blieb bis über 550° C unverändert.

**Ansprüche**

1. Verfahren zur Herstellung von hochtemperaturbeständigen, insbesondere blasenfreien, Metallschichten auf Keramikoberflächen, durch galvanische Metallabscheidung, dadurch gekennzeichnet, daß wasserfreie oder wasserarme galvanische Bäder verwendet werden.

2. Verfahren nach Anspruch 1, dadurch gekennzeichnet, daß Bäder auf Basis organischer Lösungsmittel verwendet werden.

3. Verfahren nach Anspruch 2, dadurch gekennzeichnet, daß die Lösungsmittel polare Gruppen enthalten oder $\pi$-Komplexe bilden können.

4. Verfahren nach Anspruch 2, dadurch gekennzeichnet, daß als Lösungsmittel, Ethanol, i-Propanol, n-Butanol, Diethylether, Tetrahydrofuran, Diethylenglykolether, Toluol, Xylol, N,N-Dimethylformamid, N-Methylpyrrolidon oder Acetylaceton verwendet werden.

5. Verfahren gemäß Anspruch 1, dadurch gekennzeichnet, daß der Wassergehalt der Lösungsmittel kleiner als 1 Gewichtsprozent ist.

6. Verfahren nach Anspruch 1, dadurch gekennzeichnet, daß galvanische Bäder auf Basis der Metalle Blei, Cadmium, Chrom, Eisen, Gold, Kobalt, Kupfer, Nickel, Palladium, Platin, Zink, Zinn, Rhodium in Form ihrer Verbindungen verwendet werden.

7. Verfahren nach Anspruch 6, dadurch gekennzeichnet, daß als Metallverbindung deren Salze mit anorganischen oder organischen Säuren verwendet werden.

8. Verfahren nach Anspruch 6, dadurch gekennzeichnet, daß die Metallverbindungen in Konzentrationen von 0,1 bis 150 g/Liter Badlösung bezogen auf den Metallgehalt angewendet werden.

9. Keramiksubstraten mit hochtemperaturbeständigen Metallschichten, hergestellt nach Verfahren gemäß Ansprüchen 1 bis 8.

10. Verwendung von wasserfreien oder wasserarmen galvanischen Bädern auf Basis organischer Lösungsmittel zur Herstellung von hochtemperaturbeständigen, insbesondere blasenfreien Metallschichten auf Keramikoberflächen.